# EUROPEAN PATENT APPLICATION

(11) **EP 2 445 029 A1**
(43) Date of publication of application: **25.04.2012**
(21) Application number: 10188769.3
(22) Date of filing: 25.10.2010
(51) Int. Cl.: H01L 51/52

(54) **Multilayered protective layer, organic opto-electric device and method of manufacturing the same**

(71) Applicant: Nederlandse Organisatie voor Toegepast -Natuurwetenschappelijk Onderzoek TNO, 2628 VK Delft (NL); Koninklijke Philips Electronics N.V., 5621 BA Eindhoven (NL); Huntsman Advanced Materials (Switzerland) GmbH, 4057 Basel (CH)
(72) Inventor: Van de Weijer, Peter, 5621 BA Eindhoven (NL); Van Mol, Antonius Maria Bernardus, 2628 VK Delft (NL); Galand, Emilie, F-68300 Saint Louis La Chaussee (FR); Frantz, Richard, F-68128 Village Neuf (FR); Kotzev, Dimiter Lubomirov, CH-4057 Basel (CH)
(74) Representative: Jansen, Cornelis Marinus

(57) **Abstract**

An organic opto-electric device is disclosed comprising an opto-electric element (10) and a protective enclosure (20) for protecting the opto-electric element (10) against atmospheric substances. The protective enclosure comprises a multi-layered protective layer (30) in which a first inorganic layer (32), a first organic layer (34) comprising a getter, a second organic layer (36) free from getter material and a second inorganic layer (38) are stacked in the order named, wherein the first and the second inorganic layer encapsulate the first and the second organic layer. The getter is distributed in the first organic layer (34) as nanometer sized particles and the second organic layer (36) has a thickness of at least 10 µm.

## Description

### BACKGROUND

### Field of the invention

The present invention relates to a multilayered protective layer.

The present invention further relates to an organic opto-electric device.

The present invention further relates to a method of manufacturing a multilayered protective layer.

The present invention further relates to a method of manufacturing an organic opto-electric device.

### Related Art

Exposure of moisture sensitive devices such as organic LEDs (both small molecule and polymer based), OPV, CI(G)S solar cells, to the ambient atmosphere results in loss of performance of the device. In the case of OLEDs, ingress of water or of other oxidising materials can lead to degradation of the active organic layers leading to loss of efficiency or to oxidation of the cathode leading to local failure of the device.

Water ingress can come from two sides, from the anode side or the cathode side. Current state-of-the-art OLEDs are protected from water ingress by using glass as a substrate and glass or metal lids to encapsulate on the cathode side. Conventionally, encapsulation is performed with a coverlid glued at the edges. A getter is used to consume water that might penetrate through the glue. This encapsulation method is expensive and is not functional for large-area devices, especially flexible ones.

A more cost-effective alternative, which also will allow flexible devices, is the use of thin film barriers, which can be applied on a plastic foil to act as substrate and which can be used as final encapsulation.

In order to understand the issues with such kind of barrier, a brief explanation is given below about the mechanism of water ingress in an OLED: The cathode in an OLED device most often consists of a thin (1-10 nm) layer of Ba (polymer LED) or LiF (small molecule OLED) covered with a relatively thick Al layer.

Aluminum would be an excellent barrier against water if not for the fact that it contains pinholes, of which most of them are caused by particles. Such particles originate from a plurality of causes and their presence is in practice difficult to avoid. Water from the ambient atmosphere is penetrating through pinholes in the cathode layer. Oxidation of metal at the cathode-polymer interface prevents electron injection from the cathode into the polymer during operation of the device, thus introducing a local spot without emission, i.e. a black spot in the bright field of electroluminescence. The evolution of the black spots is determined by the diffusion rate of water from the pinhole. The area of the resulting circular shaped spots increases linearly with time. Black spot formation and growth is a shelf effect, i.e. no current or voltage is necessary to drive the process.

When an inorganic barrier layer is applied on top of the OLED the majority of the particles is covered, resulting in a corresponding decrease in the number of black spots. Still the remaining black spot density is far too large for any practical application. Increase of the thickness of the barrier layer hardly reduces the pinhole density. Once a pinhole is present in such a layer it tends to continue while depositing more of the same material.

Graff et al. describe in "Mechanisms of vapor permeation through multilayer barrier films: Lag time versus equilibrium permeation", J. of Applied Physics, Vol. 96, Nr. 4, pp. 1840-1849 a now common strategy to interrupt the growth of the barrier layer by organic layers. In this way the pinholes in subsequent barrier layers are decoupled resulting in a tortuous path for water transport form the ambient atmosphere to the cathode in the device. Also other layers of different chemical composition, such as other inorganic materials are used for this purpose. Graff et al. investigated use of polymer decoupling layers having a thickness in the range of 0.1 to 3 µm and suggested that even thinner polymer decoupling layers could result in further improvement.

US2009289549A describes an OLED display provided with a multi-layered protective layer, wherein organic and inorganic layers are alternately stacked in a repeated manner and at least one moisture absorbing layer is interposed in the multi-layered protective layer. In particular US2009289549A describes an embodiment wherein the multi-layered protective layer comprises a.o. a first inorganic layer, a moisture absorbing layer, an organic layer and a second inorganic layer in this order. The presence of the moisture absorbing layer further reduces the ingress of water towards the opto-electric element. The moisture absorbing layer is formed of an organic metal compound solution and may contain additives such as a metal or a metal oxide. The moisture absorbing layer may have a thickness in the range of 3 to 50 nm. It is remarked in US2009289549A that the organic layer between the moisture absorbing layer and the second inorganic layer may have a thickness larger than the thickness of the moisture absorbing layer. The cited US patent does not disclose more specifically how much larger the thickness should be, but the drawing that is referred to suggests that the second organic layer is about two to three times thicker.

### SUMMARY

It is an object of the present invention to provide a multi-layered protective layer having an improved barrier against atmospheric substances.

It is a further object of the present invention to provide an opto-electric device having an improved barrier against atmospheric substances.

It is a further object of the present invention to provide a method of manufacturing such a multi-layered protective layer.

It is a further object of the present invention to provide a method of manufacturing such an opto-electric device.

According to a first aspect of the invention a multi-layered protective layer is provided comprising
- a first inorganic layer,
- a first organic layer comprising a getter material,
- a second organic layer free from getter material and
- a second inorganic layer, which layers are stacked in the order named, wherein the first and the second inorganic layer encapsulate the first and the second organic layer,
characterized in that the getter material is distributed in the first organic layer as nanometer sized particles and in that the second organic layer has a thickness of at least 10 µm.
According to a second aspect of the invention an organic opto-electric device is provided comprising
- an opto-electric element,
- a protective enclosure for protecting the opto-electric element against atmospheric substances, said protective enclosure comprising a multi-layered protective layer according to the first aspect of the invention.

Nanometer sized particles, hereinafter also denoted as nano-particles, are understood to be particles having dimensions less than 200 nm.

The present invention is based on the observation by the inventors that despite the small size of the original getter particles, these particles tend to form clusters having a size of several micrometers. It has been found that milling of the getter particles results in a distribution having a small average cluster size, so that the layer comprising the particles has a good transparency. Despite this small average cluster size, it appeared that the presence of large clusters could not be fully ruled out. According, when applying a second organic layer over the first organic layer, having a conventional thickness in the range of 0.1 to 3 µm, these clusters may protrude through the second organic layer and the particles at the surface of the clusters tend to cause defects in the inorganic layer. According to the present invention the second organic layer has a thickness substantially greater than the thickness that is conventionally applied. The first and the second inorganic layer encapsulate the first and the second organic layer so that a lateral ingress of moisture is prevented.

Nanometer sized particles provide for an efficient binding of moisture in the first organic layer. The present invention is particularly relevant to embodiments wherein the nano-particles comprised in the organic layer are provided with an amount of 4 to 20% by weight based on the total weight of the composition. However, particular at these higher amounts the nano-particles tend to cluster. In typical embodiments the amount is in the range of 5 to 10 % by weight based on the total weight of the composition, for example 5 wt%.

In a preferred embodiment the thickness of the second organic layer is at least 20 µm. This has the advantage that even if tolerances in the manufacturing process cause variations in the thickness of the second organic layer then the remaining thickness is still larger than the required 10 µm. For a flexible product it is preferred that the thickness of the second organic layer is less than 100 µm. In a typical embodiment the second organic layer has a thickness of about 70 µm.

In an embodiment the first organic layer has a thickness in the range of 10 to 100 µm. A substantially smaller thickness e.g. less than 5 µm would have an insufficient getter capacity, while a substantially larger thickness, e.g. more than 200 µm would be undesirable for a flexible product.

In an embodiment the nanometer sized particles are composed of a metal oxide.

In an embodiment the metal oxide is an alkaline earth metal oxide. Alkaline earth metal oxides, in particular CaO provide for a very efficient binding of water.

In an embodiment the opto-electric element is an OLED, having an opto-electric layer arranged between a cathode and an anode, and the cathode faces the multi-layered protective layer. The cathode side of the OLED is the most vulnerable to moisture, against which the multi-layered protective layer provides a efficient yet transparent protection. At the opposite side of the OLED another protective layer may be arranged, for example a metal foil. The metal foil may also serve as a conductor for one of the cathode and the electrode. In another embodiment the opto-electric element has a multi-layered protective layer as described above on both sides.

The resinous component of the organic layers is not particularly restricted provided that in the first organic layer, the water-removing action of the getter material is not interfered with. Suitable resins are for example, fluorine-containing resin, polyolefin resin, polyacrylic resin, polyacrylonitrile resin, polyamide resin, polyester resin, epoxy resin, polysiloxane resin, and polycarbonate resin.

These resins may be applied for example by extrusion in a molten state. Epoxy resins are typically thermally cured or cured at room temperature in two-component systems.

Among these resins, those that result from photocurable compositions comprising at least one radically curable compound and radical photoinitiator are preferred. The advantage of using photocurable compounds is that curing time is almost instantaneous.

The photocurable composition comprises one or more radically polymerizable compounds. The radically polymerizable compound is preferably ethylenically unsaturated, and is particularly preferably selected from compounds (monofunctional or polyfunctional compounds) having at least a terminal ethylenic unsaturated bond and more preferably two or more thereof. More specifically, it can be suitably selected from those widely known in the radiation curing industry, including those having a chemical structure of a monomer, a prepolymer (namely a dimer, a trimer, and an oligomer), a mixture thereof and a copolymer thereof.

Examples of radical polymerizable compounds include (meth)acrylates, (meth)acrylamides, aromatic vinylic compounds, vinyl ethers and compounds having an internal double bond (such as maleic acid). In the expression, "(meth)acrylate" refers to an acrylate, a methacrylate, or a mixture thereof, "(meth)acryl" refers to an acryl, a methacryl, or a mixture thereof.

### Examples of (meth)acrylates include those shown below.

Specific examples of mono functional (meth)acrylate include hexyl (meth)acrylate, 2-ethylhexyl (meth)acrylate, tert-octyl (meth)acrylate, isoamyl (meth)acrylate, decyl (meth)acrylate, isodecyl (meth)acrylate, stearyl (meth)acrylate, isostearyl (meth)acrylate, cyclohexyl (meth)acrylate, 4-n-butylcyclohexyl (meth)acrylate, bornyl (meth)acrylate, isobornyl (meth)acrylate, benzyl (meth)acrylate, 2-ethylhexyl diglycol (meth)acrylate, butoxyethyl (meth)acrylate, 2-chloroethyl (meth)acrylate, 4-bromobutyl (meth)acrylate, butoxymethyl (meth)acrylate, 3-methoxybutyl (meth)acrylate, alkoxymethyl (meth)acrylate, alkoxyethyl (meth)acrylate, 2-(2-methoxyethoxy)ethyl (meth)acrylate, 2-(2-butoxyethoxy)ethyl (meth)acrylate, 2,2,2-trifluoroethyl (meth)acrylate, 1H,1H,2H,2H-perfluorodecyl (meth)acrylate, 4-butylphenyl (meth)acrylate, phenyl (meth)acrylate, 2,3,4,5-tetramethylphenyl (meth)acrylate, 4-chlorophenyl (meth)acrylate, phenoxymethyl (meth)acrylate, phenoxyethyl (meth)acrylate, glycidyl (meth)acrylate, glycidyloxybutyl (meth)acrylate, glycidyloxyethyl (meth)acrylate, glycidyloxypropyl (meth)acrylate, tetrahydrofurfuryl (meth)acrylate, hydroxyalkyl (meth)acrylate, 2-hydroxyethyl (meth)acrylate, 3-hydroxypropyl (meth)acrylate, 2-hydroxypropyl (meth)acrylate, 2-hydroxybutyl (meth)acrylate, 4-hydroxybutyl (meth)acrylate, dimethylaminoethyl (meth)acrylate, diethylaminoethyl (meth)acrylate, dimethylaminopropyl (meth)acrylate, diethylaminopropyl (meth)acrylate, trimethoxysilylpropyl (meth)acrylate, trimethylsilylpropyl (meth)acrylate, polyethylene oxide monomethyl ether (meth)acrylate, oligoethylene oxide monomethyl ether (meth)acrylate, polyethylene oxide (meth)acrylate, oligoethylene oxide (meth)acrylate, oligoethylene oxide monoalkyl ether (meth)acrylate, polyethylene oxide monoalkyl ether (meth)acrylate, dipropylene glycol (meth)acrylate, polypropylene oxide monoalkyl ether (meth)acrylate, oligopropylene oxide monoalkyl ether (meth)acrylate, 2-methacryloyloxyethylsuccinic acid, 2-methylacryloyloxyhexahydrophthalic acid, 2-methacryloyloxyethyl-2-hydroxypropyl phthalate, butoxydiethylene glycol (meth)acrylate, trifluoroethyl (meth)acrylate, perfluorooctylethyl (meth)acrylate, 2-hydroxy-3-phenoxypropyl (meth)acrylate, EO-denatured phenol (meth)acrylate, EO-denatured cresol (meth)acrylate, EO-denatured nonylphenol (meth)acrylate, PO-denatureed nonylphenol (meth)acrylate, and EO-denatured 2-ethylhexyl (meth)acrylate.

Specific examples of bifunctional (meth)acrylate include 1,6-hexanediol di(meth)acrylate, 1,10-decanediol di(meth)acrylate, 1,12-dodecanediol di(meth)acrylate, neopentyl glycol di(meth)acrylate, 2,4-dimethyl-1,5-pentanediol di(meth)acrylate, butylethylpropanediol (meth)acrylate, ethoxylated cyclohexanemethanol di(meth)acrylate, polyethylene glycol di(meth)acrylate, oligoethylene glycol di(meth)acrylate, ethylene glycol di(meth)acrylate, 2-ethyl-2-butyl-butanediol di(meth)acrylate, neopentyl glycol hydroxypivalate di(meth)acrylate, EO-denatured bisphenol-A di(meth)acrylate, bisphenol-F polyethoxy di(meth)acrylate, polypropylene glycol di(meth)acrylate, oligopropylene glycol di(meth)acrylate, 1,4-butanediol di(meth)acrylate, 2-ethyl-2-butylpropanediol di(meth)acrylate, 1,9-nonane di(meth)acrylate, propoxylated ethoxylated bisphenol-A di(meth)acrylate, and tricyclodecane di(meth)acrylate.

Specific examples of trifunctional (meth)acrylate include trimethylolpropane tri(meth)acrylate, trimethylolethane tri(meth)acrylate, alylene oxide-denatured tri(meth)acrylate of trimethylolpropane, pentaerythritol tri(meth)acrylate, dipentaerythritol tri(meth)acrylate, trimethylolpropane tris((meth)acryloyloxypropyl)ether, alkylene-denatured tri(meth)acrylate of isocyanuric acid, dipentaerythritol propionate tri(meth)acrylate, tris((meth)acryloyloxyethyl)isocyanurate, hydroxypivalyl aldehyde-denatured dimethylolpropane tri(meth)acrylate, sorbitol tri(meth)acrylate, propoxylated trimethylolpropane tri(meth)acrylate, and ethoxylated glycerin triacrylate. Specific examples of tetrafunctional (meth)acrylate include pentaerythritol tetra(meth)acrylate, sorbitol tetra(meth)acrylate, ditrimethylolpropane tetra(meth)acrylate, dipentaerythritol propionate tetra(meth)acrylate, and ethoxylated pentaerythritol tetra(meth)acrylate.

Specific examples of pentafunctional (meth)acrylate include sorbitol penta(meth)acrylate, and dipentaerythritol penta(meth)acrylate.

Specific examples of hexafunctional (meth)acrylate include dipentaerythritol hexa(meth)acrylate, sorbitol hexa(meth)acrylate, alkylene oxide-denatured hexa(meth)acrylate of phosphazene, and captolactone-denatured dipentaerythritol hexa(meth)acrylate.

Unsaturated (poly)urethanes may be used. The unsaturated (poly)urethane is an unsaturated urethane compound or an unsaturated (poly)urethane compound having at least one polymerizable carbon-carbon unsaturated bond in the molecule. Unsaturated (poly)urethanes may be prepared by, e.g., reacting a hydroxyl-terminated (poly)urethane with (meth)acrylic acid, or by reacting an isocyanate-terminated prepolymer with hydroxyalkyl (meth)acrylates to give an urethane methacrylate.

Examples of preferred aliphatic urethane methacrylates include GrenomerR 4205, GrenomerR 4256 and GrenomerR 4297, or those described in patent application US 6,277,929.

Furthermore, higher functionality methacrylates, including hyberbranched polyester types, may also be used.

Examples of (meth)acrylamides include (meth)acrylamide, N-methyl(meth)acrylamide, N-ethyl(meth)acrylamide, N-propyl(meth)acrylamide, N-n-butyl(meth)acrylamide, N-t-butyl(meth)acrylamide, N-butoxymethyl(meth)acrylamide, N-isopropyl(meth)acrylamide, N-methylol(meth)acrylamide, N,N-dimethyl(meth)acrylamide, N,N-diethyl(meth)acrylamide, and (meth)acryloylmorpholine.

Specific examples of aromatic vinyl compound include styrene, methylstyrene, dimethylstyrene, trimethylstyrene, ethylstyrene, isopropylstyrene, chloromethylstyrene, methoxystyrene, acetoxystyrene, chlorostyrene, dichlorostyrene, bromostyrene, vinylbenzoic acid methyl ester, 3-methylstyrene, 4-methylstyrene, 3-ethylstyrene, 4-ethylstyrene, 3-propylstyrene, 4-propylstyrene, 3-butylstyrene, 4-butylstyrene, 3-hexylstyrene, 4-hexylstyrene, 3-octylstyrene, 4-octylstyrene, 3-(2-ethylhexyl)styrene, 4-(2-ethylhexyl)styrene, allylstyrene, isopropenylstyrene, butenylstyrene, octenylstyrene, 4-t-butoxycarbonylstyrene, 4-methoxystyrene, and 4-t-butoxystyrene.

Specific examples of the vinyl ethers, in the case of a monofunctional vinyl ether, include methyl vinyl ether, ethyl vinyl ether, propyl vinyl ether, n-butyl vinyl ether, t-butyl vinyl ether, 2-ethylhexyl vinyl ether, n-nonyl vinyl ether, lauryl vinyl ether, cyclohexyl vinyl ether, cyclohexylmethyl vinyl ether, 4-methylcyclohexylmethyl vinyl ether, penzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, and phenoxypolyethylene glycol vinyl ether.

Also examples of polyfunctional vinyl ether include divinyl ethers such as ethylene glycol divinyl ether, diethylene glycol divinyl ether, polyethylene glycol divinyl ether, propylene glycol divinyl ether, butylene glycol divinyl ether, hexanediol divinyl ether, bisphenol-A alkylene oxide divinyl ether, and bispenol-F alkylene oxide divinyl ether; and polyfunctional vinyl ethers such as trimethylolethane trivinyl ether, trimethylolpropane trivinyl ether, ditrimethylolpropane tetravinyl ether, glycerin trivinyl ether, pentaerythritol tetravinyl ether, dipentaerythritol pentavinyl ether, dipentaerythritol hexavinyl ether, ethylene oxide-added trimethylolpropane trivinyl ether, propylene oxide-added trimethylolpropane trivinyl ether, ethylene oxide-added ditrimethylolpropane tetravinyl ether, propylene oxide-added ditrimethylolpropane tetravinyl ether, ethylene oxide-added pentaerythritol tetravinyl ether, propylene oxide-added pentaerythritol tetravinyl ether, ethylene oxide-added dipentaerythritol hexavinyl ether, and propylene oxide-added dipentaerythritol hexavinyl ether.

In addition, the photocurable composition comprises at least one free radical photoinitiator. The free radical photoinitiator may be chosen from those commonly used to initiate radical photopolymerization. Examples of free radical photoinitiators include benzoins, e.g., benzoin, benzoin ethers such as benzoin methyl ether, benzoin ethyl ether, benzoin isopropyl ether, benzoin phenyl ether, and benzoin acetate; acetophenones, e.g., acetophenone, 2,2-dimethoxyacetophenone, and 1,1-dichloroacetophenone; benzil ketals, e.g., benzil dimethylketal and benzil diethyl ketal; anthraquinones, e.g., 2-methylanthraquinone, 2-ethylanthraquinone, 2-tertbutylanthraquinone, 1-chloroanthraquinone and 2-amylanthraquinone; triphenylphosphine; benzoylphosphine oxides, e.g., 2,4,6-trimethylbenzoy-diphenylphosphine oxide (Lucirin TPO); bisacylphosphine oxides; benzophenones, e.g., benzophenone and 4,4'-bis(N,N'-dimethylamino)benzophenone; thioxanthones and xanthones; acridine derivatives; phenazine derivatives; quinoxaline derivatives; 1-phenyl-1,2-propanedione 2-O-benzoyl oxime; 4-(2-hydroxyethoxy)phenyl-(2-propyl)ketone (Irgacure® 2959); 1-aminophenyl ketones or 1-hydroxy phenyl ketones, e.g., 1-hydroxycyclohexyl phenyl ketone, 2-hydroxyisopropyl phenyl ketone, phenyl 1-hydroxyisopropyl ketone, and 4-isopropylphenyl 1-hydroxyisopropyl ketone, and combinations thereof.

The content of the polymerization initiator is preferably within a range from 0.01 to 10% by mass with respect to the polymerizable material, more preferably from 0.5 to 7% by mass.

The photocurable composition may be a thiol-ene system. Therefore, the resin composition may comprise at least a monofunctional or multifunctional thiol in addition to the (meth)acrylate components and free radical photoinitiator. Multifunctional thiol means a thiol with two or more thiol groups. A multifunctional thiol may be a mixture of different multifunctional thiols. Suitable multifunctional thiols are described in U.S. Pat. No. 3,661,744 at Col. 8, line 76-Col. 9, line 46; in

U.S. Pat. No. 4,119,617, Col. 7, lines 40-57; U.S. Pat. Nos. 3,445,419 and 4,289,867. Especially preferred are multifunctional thiols obtained by esterification of a polyol with an .alpha. or s-mercaptocarboxylic acid such as thioglycolic acid, or s-mercaptopropionic acid.

Examples of thiols include pentaerythritol tetra-(3-mercaptopropionate) (PETMP), pentaerythritol tetrakis(3-mercaptobutylate) (PETMB), trimethylolpropane tri-(3-mercaptopropionate) (TMPMP), glycol di-(3-mercaptopropionate) (GDMP), pentaerythritol tetramercaptoacetate (PETMA), trimethylolpropane trimercaptoacetate (TMPMA), glycol dimercaptoacetate (GDMA), ethoxylated trimethylpropane tri(3-mercaptopropionate) 700 (ETTMP 700), ethoxylated trimethylpropane tri(3-mercaptopropionate) 1300 (ETTMP 1300), propylene glycol 3-mercaptopropionate 800 (PPGMP 800).

A dispersant may be added in order to increase dispersibility of getter particles into the organic matrix. The dispersant may be a low molecular weight organic dispersant, a high molecular weight organic dispersant, a low molecular weight organic/inorganic complex dispersant, a high molecular weight organic/inorganic complex dispersant, an organic/inorganic acid, or the like. The dispersant is to disperse the getter particles well in the organic layer, for example, by avoiding aggregation, and thus minimize the size of the getter particles, to eventually make them exist on the order of nm to make a transparent moisture absorption layer.

The photocurable composition may additionally include other components, for example, stabilizers, modifiers, tougheners, antifoaming agents, leveling agents, thickening agents, flame retardants, antioxidants, pigments, dyes, fillers, and combinations thereof.

The photocurable composition may comprise one or more cationically polymerizable epoxy polysiloxane compounds.

Examples of such epoxy polysiloxane components are: Bis[2-(3,4-epoxycyclohexyl)ethyl]tetramethyldisiloxane, 1,3-bis(glycidoxypropyl) tetramethyldisiloxane, epoxypropoxypropyl terminated
polydimethylsiloxanes, epoxypropoxypropyl terminated
polyphenylmethylsiloxanes, (epoxypropoxypropyl)dimethoxysilyl terminated polydimethylsiloxanes, mono-(2,3-epoxy)propylether terminated polydimethylsiloxane, epoxycyclohexylethyl terminated
polydimethylsiloxanes.

The following are examples of commercially available epoxy polysiloxane components: DMS-E12, DMS-E21, DMS-EX21, MCR-E11, MCR-E21, DMS-EC13, SIB1115.0 (Gelest); UV9200 (Momentive), Silcolease UV POLY220, Silcolease UV POLY200, Silcolease UV POLY201 (Bluestar), PC1000, PC1035 (Polyset).

Therefore, the resin composition may comprise epoxy and/or oxetane functional organic compounds to modify cure performance, adhesion, mechanical properties, and viscosity. Epoxy functional organic compounds include for example epoxidized polybutadiene resins, limoneneoxide, 4-vinylcyclohexeneoxide, allylglycidyl ether, 7-epoxy-1-octene, vinylcyclohexenedioxide, bis(2,3-epoxycyclopentyl)ether, 3,4-epoxycyclohexylmethyl-3,4-epoxycyclohexanecarboxylate, cresylglycidyl ether, butanedioldiglycidyl ether and the like. Mixtures of such epoxides are also suitable. Oxetane functional organic compounds include for example 3-ethyl-3-((2-ethylhexyloxy)methyl)oxetane, trimethylolpropane oxetane.

In addition, the photocurable composition comprises at least one cationic photoinitiator.

Examples of cationic photoinitiators include, but are not limited to, onium salts, diaryliodonium salts of sulfonic acids, triarylsulfonium salts of sulfonic acids, diaryliodonium salts of boronic acids, and triarylsulfonium salts of boronic acids, having non-nucleophilic anions such as hexafluorophosphate, hexafluoroantimonate, tetrafluoroborate and hexafluoroarsenate, tetra(pentafluorophenyl)borate.

The cationic photoinitiator can be present in the coating composition in an amount ranging from about 0.01 to 10%, preferably from 0.1 to 5% weight percent, more preferably from 0.5 to 3% based on the total weight of the coating composition.

The onium salts are positively charged, usually with a value of +1, and a negatively charged counterion is present. Suitable onium salts include salts having a formula selected from R⁹₂I+MX_{z}-, R⁹₃S+MX_{z}-, R⁹₃ Se+MX_{z}-, R⁹₄P+MX_{z}-, and R⁹₄N⁺MX_{z}-, wherein each R⁹ is independently hydrocarbyl or substituted hydrocarbyl having from 1 to 30 carbon atoms; M is an element selected from transition metals, rare earth metals, lanthanide metals, metalloids, phosphorus, and sulfur; X is a halo (e.g., chloro, bromo, iodo), and z has a value such that the product of z times (charge on X + oxidation number of M) = -1. Examples of substituents on the hydrocarbyl group include, but are not limited to, C₁ to C₈ alkoxy, C₁ to C₁₆ alkyl, nitro, chloro, bromo, cyano, carboxyl, mercapto, and heterocyclic aromatic groups, such as pyridyl, thiophenyl, and pyranyl. Examples of metals represented by M include, but are not limited to, transition metals, such as Fe, Ti, Zr, Sc, V, Cr, and Mn; lanthanide metals, such as Pr, and Nd; other metals, such as Cs, Sb, Sn, Bi, Al, Ga, and In; metalloids, such as B, and As; and P. The formula MX_{z}-represents a non-basic, non-nucleophilic anion. Examples of anions having the formula MX_{z}- include, but are not limited to, BF₄-, PF₆-, AsF₆-, SbF₆-, SbCl₆-, and SnCl₆-.

Examples of onium salts include, but are not limited to, bis-diaryliodonium salts, such as bis(dodecylphenyl)iodonium hexafluoroarsenate, bis(dodecylphenyl)iodonium hexafluoroantimonate, and
dialkylphenyliodonium hexafluoroantimonate.

Examples of diaryliodonium salts of sulfonic acids include, but are not limited to, diaryliodonium salts of perfluoroalkylsulfonic acids, such as diaryliodonium salts of perfluorobutanesulfonic acid, diaryliodonium salts of perfluoroethanesulfonic acid, diaryliodonium salts of perfluorooctanesulfonic acid, and diaryliodonium salts of trifluoromethanesulfonic acid; and diaryliodonium salts of aryl sulfonic acids, such as diaryliodonium salts of para-toluenesulfonic acid, diaryliodonium salts of dodecylbenzenesulfonic acid, diaryliodonium salts of benzenesulfonic acid, and diaryliodonium salts of 3-nitrobenzenesulfonic acid.

Examples of triarylsulfonium salts of sulfonic acids include, but are not limited to, triarylsulfonium salts of perfluoroalkylsulfonic acids, such as triarylsulfonium salts of perfluorobutanesulfonic acid, triarylsulfonium salts of perfluoroethanesulfonic acid, triarylsulfonium salts of perfluorooctanesulfonic acid, and triarylsulfonium salts of trifluoromethanesulfonic acid; and triarylsulfonium salts of aryl sulfonic acids, such as triarylsulfonium salts of para-toluenesulfonic acid, triarylsulfonium salts of dodecylbenzenesulfonic acid, triarylsulfonium salts of benzenesulfonic acid, and triarylsulfonium salts of 3-nitrobenzenesulfonic acid.

Examples of diaryliodonium salts of boronic acids include, but are not limited to, diaryliodonium salts of perhaloarylboronic acids. Examples of triarylsulfonium salts of boronic acids include, but are not limited to, triarylsulfonium salts of perhaloarylboronic acid. Diaryliodonium salts of boronic acids and triarylsulfonium salts of boronic acids are well known in the art, as exemplified in European Patent Application No. EP 0562922.

Examples of commercial cationic photoinitiators include UV9390C, UV9380C (manufactured by Momentive), Irgacure 250 (BASF), Rhodorsil 2074, Rhodorsil 2076 (Rhodia), Uvacure 1592 (UCB Chemicals), Esacure 1064 (Lamberti). Most preferred are UV9390C and Rhodorsil 2074.

In an embodiment of the multi-layered protective layer according to the first aspect the first organic layer and/or the second organic layer are obtained by curing with actinic radiation, e.g. with UV radiation a photocurable resin composition comprising:
(A) at least one aromatic acrylate or methacrylate component, or any mixture thereof;
(B) at least one monofunctional acrylate, methacrylate, vinylamide, acrylamide or methacrylamide component, preferably with a viscosity below 100 mPa• s at 30°C, or any mixture thereof;
(C) at least one photoinitiator, or any mixture thereof.

In an embodiment of said embodiment the photocurable resin composition comprises:
(A) 30 - 90% by weight of the aromatic acrylate or methacrylate component A;
(B) 1 - 30% by weight of the monofunctional acrylate, methacrylate, vinylamide, acrylamide or methacrylamide component B;
(C) 0.1 - 10% by weight of the photoinitiator C;
based on the total weight of the resin composition.

In an embodiment of the multi-layered protective layer according to the first aspect the first organic layer and/or the second organic layer are obtained by curing with actinic radiation a photocurable resin composition comprising:
(D) at least one polybutadiene acrylate or methacrylate component, or any mixture thereof;
(E) at least one acrylate or methacrylate component not exhibiting polybutadiene groups, preferably with a viscosity below 100 mPa •s at 30°C, or any mixture thereof;
(C) at least one photoinitiator, or any mixture thereof.

In an embodiment of said embodiment the photocurable resin composition comprises:
(D) 10 - 60% by weight of the polybutadiene acrylate or methacrylate component D;
(E) 1 - 89.9% by weight of the acrylate or methacrylate component E;
(C) 0.1 - 10% by weight of the photoinitiator C;
based on the total weight of the resin composition.

In an embodiment of the multi-layered protective layer according to the first aspect the first organic layer and/or the second organic layer are obtained by curing with actinic radiation a photocurable resin composition comprising:
(F) at least one urethane acrylate or methacrylate component, or any mixture thereof;
(E) at least one acrylate or methacrylate component not exhibiting urethane groups, preferably with a viscosity below 100 mPa •s at 30°C, or any mixture thereof;
(C) at least one photoinitiator, or any mixture thereof.

In an embodiment of said embodiment the photocurable resin composition comprises:
(F) 5- 50% by weight of the urethane acrylate or methacrylate component F;
(E) 1 - 94.9% by weight of the acrylate or methacrylate component E;
(C) 0.1 - 10% by weight of the photoinitiator C;
based on the total weight of the resin composition.

In an embodiment of the multi-layered protective layer according to the first aspect the first organic layer and/or the second organic layer are obtained by curing with actinic radiation a photocurable resin composition comprising:
(G) at least one acrylate or methacrylate component, or any mixture thereof with a ClogP value >2;
(H) at least one thiol component, or any mixture thereof;
(C) at least one photoinitiator, or any mixture thereof.

In an embodiment of said embodiment the photocurable resin composition comprises:
(G) 20 - 98.9% by weight of the acrylate or methacrylate component G;
(H) 1 - 20% by weight of the thiol component H;
(C) 0.1 - 10% by weight of the photoinitiator C;
based on the total weight of the resin composition.

In an embodiment of the multi-layered protective layer according to the first aspect the first organic layer and/or the second organic layer are obtained by curing with actinic radiation a photocurable resin composition comprising:
(I) at least one epoxy polysiloxane component;
(J) at least one cationic photo initiator, or any mixture thereof.

In an embodiment of said embodiment the photocurable resin composition comprises:
(I) 20 - 99.9% by weight of the epoxy polysiloxane component I;
(K) 0.2-79.9% by weight of an epoxy or oxetane functional organic component or mixture of epoxy or oxetane functional organic components not exhibiting polysiloxane groups.
(J) 0.1 - 10% by weight of the photoinitiator J;
based on the total weight of the resin composition.

For application in the first organic layer this composition should only be used in combination with getter materials having a relatively low basicity. Getter materials having a relatively high basicity, such as CaO could suppress the cationic photocuring process.

In an embodiment of the multi-layered protective layer according to the first aspect the first organic layer and/or the second organic layer are obtained by curing with actinic radiation a photocurable resin composition with a ClogP value >2.

According to a third aspect of the invention a method of manufacturing a multi-layered protective layer is provided comprising the steps of,
depositing a first inorganic layer,
depositing a first organic layer comprising a getter material, the getter material being distributed in the first organic layer as nanometer sized particles,
depositing a second organic layer free from getter material, the second organic layer having a thickness in the range of 10 to 100 micrometer,
depositing a second inorganic layer, therewith obtaining a stack subsequently comprising the opto-electric element, the first inorganic layer, the first organic layer, the second organic layer and the second inorganic layer, wherein the first and the second inorganic layer encapsulate the first and the second organic layer.

According to a fourth aspect of the invention a method of manufacturing an opto-electric device comprising an opto-electric element encapsulated by a protective enclosure, said method comprising the steps of
- providing the opto-electric element,
- providing the protective enclosure, said step of providing the protective enclosure comprising the steps for manufacturing the multi-layered protective layer.

The protective enclosure may be obtained by combining the multi*-layered protective layer with a further protective layer, therewith encapsulating the opto-electric element between the multi-layered protective layer as described above and the further protective layer. The further protective layer may also be such a multi-layered protective layer, but may alternatively be another barrier structure, e.g. a stack of inorganic layers, such as silicon oxide layers and siliconnitride layers alternating each other. In a further embodiment the opto-electric device may comprise a substrate that itself functions as a barrier layer, for example in case where a metal foil or a glass plate is used as the substrate.

Also additional steps may be applied between subsequent steps of the methods according to the third and fourth aspect of the invention. For example subsequent to the step of providing a first inorganic layer and before the step of providing the first organic layer a further organic layer may be applied in an additional step, so that said further organic layer is sandwiched between the first inorganic layer and the first organic layer.

### BRIEF DESCRIPTION OF THE DRAWINGS

These and other aspects are described in more detail with reference to the drawing. Therein:
FIG. 1 schematically shows in top-view a first embodiment of an opto-electric device according to the second aspect of the invention comprising a multilayered protective layer according to the first aspect of the invention,
FIG. 2 schematically shows a cross-section according to II-II in FIG. 1,
FIG. 3 shows in more detail a cross-section according to III-III in FIG. 1,
FIG. 4A - 4F show a first embodiment of a method according to the fourth aspect of the present invention including the steps of the method according to the third aspect of the invention,
FIG. 5 shows a SEM-photograph of a cross-section according to V in FIG. 4F,
FIG. 6 shows in a cross-section a second embodiment of an opto-electric device according to the second aspect of the invention,
FIG. 7A to 7G show a second embodiment of a method according to the fourth aspect of the present invention,
FIG. 8 shows particle size distributions,
FIG. 9 shows experimental results obtained for a relation between hydrophobicity and the ClogP value of various organic materials.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.. In case of conflict, the present specification, including definitions, will control. In addition, the materials, methods, and examples are illustrative only and not intended to be limiting.

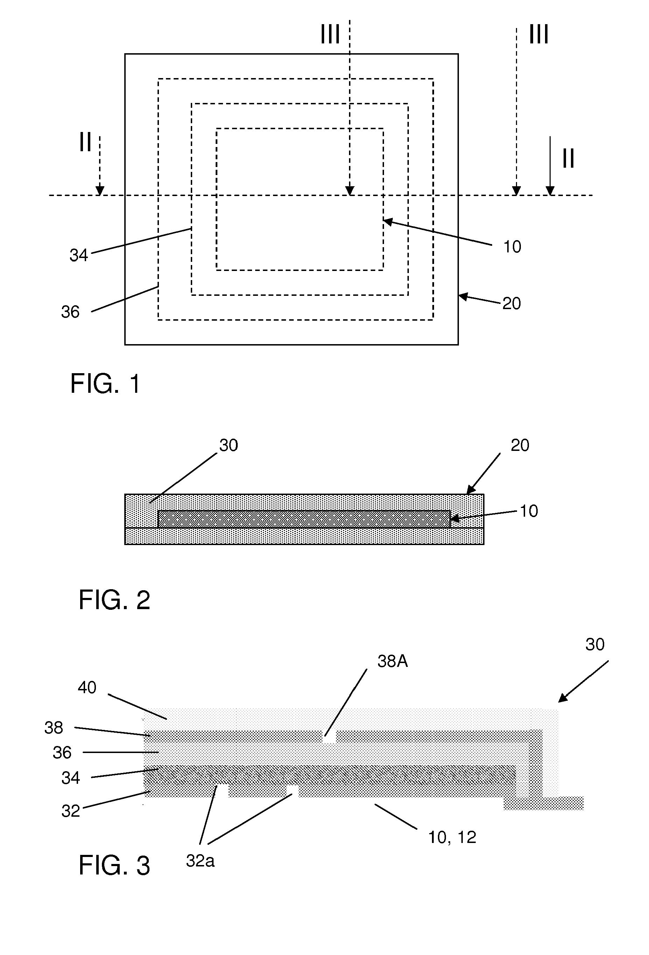

FIG. 1 schematically shows a top view of a opto-electric device. FIG. 2 schematically shows a cross-section according to II-II in FIG. 1. FIG. 3 shows more in detail a part of the cross-section according to III-III in FIG. 1 comprising the multi-layered protective layer.

The organic opto-electric device shown in FIG. 1, 2 and 3 comprises an opto-electric element 10 that is enclosed by a protective enclosure 20 for protecting the opto-electric element against atmospheric substances in particular water vapor. The protective enclosure 20 comprises a multi-layered protective layer 30 in which a first inorganic layer 32, a first organic layer 34 comprising a getter material, a second organic layer 36 free from getter material and a second inorganic layer 38 are stacked in the order named. In the embodiment shown the multilayer protective layer 30 has a further organic layer 40.

The getter material is distributed in the first organic layer 34 as nanometer sized particles with a density in the range of 4 to 20 wt%. The second organic layer 36 has a thickness in the range of 10 to 100 micrometer.

In the embodiment shown the getter material is a metal oxide, in particular an alkaline earth metal oxide. More in particular the selected alkaline earth metal oxide is calcium oxide.

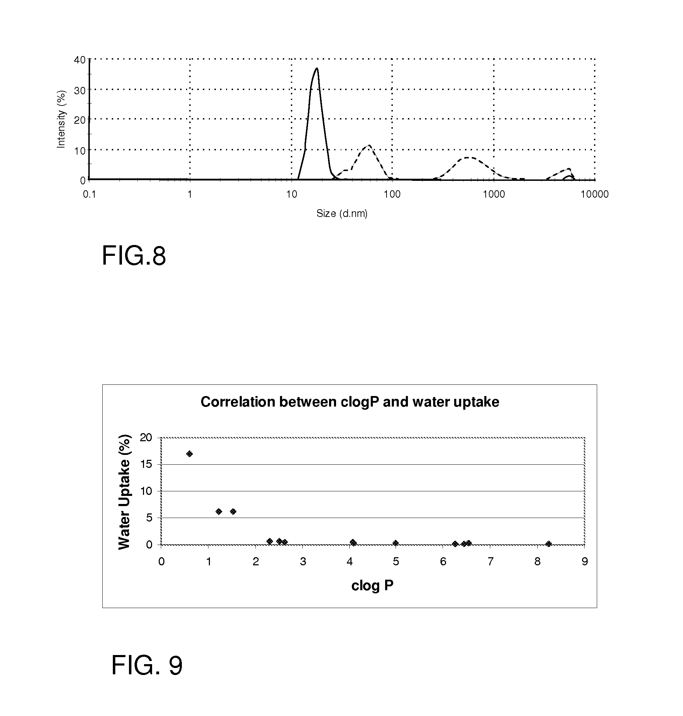

The organic material used for the first organic layer 34, the second organic layer 36 and the further organic layer may be selected from one of the photocurable compounds specified above. Preferably compounds having a high hydrophobicity are used. A good indicator for the hydrophobicity is ClogP i.e. the calculated logarithm of the octanol/water partition coefficient. A relatively high ClogP value indicates a relatively high hydrophobicity of the material. This is illustrated in FIG. 9, which shows experimental results obtained for a relation between the water uptake and the ClogP value of various organic materials. In particularly it can be seen that organic materials having a ClogP value of at least 2 show a very low water uptake. Accordingly, for the purpose of the present invention organic materials having a ClogP value of at least 2 are particular suitable. The ClogP value is a well-known parameter and may be calculated for any given molecule from a knowledge of the structure of that molecule. There are a number of commercially-available computer programs that can do this, for example, Osiris Property Explorer (http://www.organic-chemistry.org/prog/peo/), which is an integral part of Actelion's inhouse substance registration system. It is implemented as increment system adding contributions of every atom based on its atom type, the atom connectivity and chemical bonding. In particular the following compositions comprising have been found suitable in view of a high ClogP value: Siloxanes, a mixture of siloxanes in the range of 70 to 80 wt% and oxetanes in the range of 20 to 30 wt%, a mixture of acrylates in the range of 85% to 95% with at least 5 wt% of a thiol or an oxytane or a mixture of one or more acrylates in the range of 40 to 85 wt% and a polybutadiene acrylate in the range of 10 to 55%, optionally with 1 to 10% of a thiol. Further additives, such as a photoinitiator may be present to an amount of 5 wt%.

Some examples of such compositions for materials having a ClogP value of at least 2 are given in the following table (nrs in weight %).

**Table 1: Exemplary compositions of materials having a ClogP value of at least 2**

| **typename** | **F1** | **F2** | **F3** | **F4** | **F5** | **F6** | **F7** | **F8** | **F9** | **F10** |
|---|---|---|---|---|---|---|---|---|---|---|
| PC1035 | 78 | | | | | | | | | |
| PC1000 | 20 | | | | | 75 | 51,9 | | | 75 |
| UV9390C | 2 | | | | | 2 | 2 | | | |
| CN301 | | 50 | | | | | | | | |
| CD262 | | 48 | 49 | 47 | 88 | | | | | |
| Irgacure 819 | | 2 | | | | | | | | |
| SR307 | | | 50 | 47 | | | | | | |
| Lucirin TPO-L | | | 1 | 1 | 2 | | | 2 | 2 | |
| PETMP | | | | 5 | 10 | | | 10 | | |
| oxt 212 | | | | | | 23 | 23 | | 5 | |
| PolyBD 600E | | | | | | | 23 | | | |
| Dynasylan Glymo | | | | | | | 0,1 | | | |
| SR833S | | | | | | | | 70 | 93 | |
| SR506D | | | | | | | | 18 | | |
| oxt 101 | | | | | | | | | | 23 |
| Esacure 1064 | | | | | | | | | | 2 |

The meaning of the typenames is further specified in the following table.

**Table 2: Specification of typenames**

| **typename** | **manufacturer** | **chemical name** |
|---|---|---|
| **Acrylate** | | |
| | | |
| CD262 | Sartomer | 1,12 Dodecanediol dimethacrylate |
| SR833S | Sartomer | Acrylate Ester Tricyclodecane Dimethanol Diacrylate |
| SR506D | Sartomer | Isobornyl Acrylate |

| **Polybutadiene Acryl/Methacrylate** | | |
|---|---|---|
| CN301 | Sartomer | Polybutadiene Dimethacrylate/Monomer Blend |
| SR307 | Sartomer | Polybutadiene Dimethacrylate |

| **Siloxane** | | |
|---|---|---|
| PC1035 | Polyset | epoxyslicone monomer |
| PC1000 | Polyset | epoxyslicone monomer |

| **Polybutadiene Epoxy** | | |
|---|---|---|
| PolyBD 600E | Sartomer | Hydroxilated, epoxidized polybutadiene |

| **Oxetane** | | |
|---|---|---|
| oxt 212 | Toago Sei | 3-Ethyl-3(2-ethylhexyloxymethyl)oxetane |
| oxt 101 | Toago Sei | Trimethylolpropane oxetane |

| **Photoinitiator** | | |
|---|---|---|
| UV9390C | Momentive | Mixture of Bis(4-dodecylphenyl)iodonium hexafluoroantimonate and oxirane, mono [(C12-14-alkyloxy)methyl] derivatives |
| Irgacure 819 | BASF | Phenyl bis (2,4,6-trimethylbenzoyl) phosphine oxide |
| Lucirin TPO-L | BASF | dihenyl (2,4,6-trimethylbenzoyl) phosphine oxide |
| Esacure 1064 | Lamberti | Triarylsulfonium hexafluorophosphate mixture |

| **Additives** | | |
|---|---|---|
| Dynasylan Glymo | Degussa | 3-Glycidyloxypropyltrimethoxysilane |

The organic layers may be applied by all kinds of coatings techniques, such spin coating, slot-die coating, kiss-coating, hot-melt coating, spray coating, etc. and all kinds of printing techniques, such as inkjet printing, gravure printing, flexographic printing, screen printing, rotary screen printing, etc.

Subsequent to its application the layer of photocurable material may be cured by irradiation of the layer with actinic radiation, e.g. by UV radiation.

The inorganic layer(s) 32, 38 may be formed by any ceramic including but not limited to metal oxides, metal nitrides and metal carbides. Suitable materials therefore are for example silicon oxide (SiO2) aluminum oxide (Al2O3), titanium oxide (TiO2) indium oxide (In2O3), tin oxide (SnO2), indium tin oxide (ITO, In203+SnO2), silicium carbide (SiC), silicon oxynitride (SiON) and combinations thereof.

The inorganic layers 32, 38 have a water vapor transmission rate of at most 10⁻⁴ g.m⁻².day⁻¹. The inorganic layers are in practice substantially thinner than the organic layers. The inorganic layers should have a thickness in the range of 10 to 1000 nm, preferably in the range of 100 to 300 nm. An inorganic layer with a thickness less than 10 nm does in practice have insufficient barrier properties. Deposition of an inorganic layer with a thickness of at least 100 nm is preferred in that relatively large tolerances in the manufacturing process are allowed without having consequences for the quality of the product. For flexible products the thickness of the inorganic layers preferably does not exceed 300 nm. A thickness larger than 1000 nm does not further improve the barrier properties of the inorganic layer, while the duration of the deposition process is economically unattractive.

As illustrated in FIG. 3, in practice the inorganic layers 32, 38 have defects 32a, 38a, such as pinholes. The organic layers 34 and 36 serve to decouple the pinholes of the layers 32 and 38, to reduce a flow of atmospheric substances towards the opto-electric element 10. The first organic layer 34 comprising the nanometer sized metal oxide particles captures a significant portion of these substances that flow through the second inorganic layer 38. The second organic layer 36 having a thickness of at least 10 µm prevents that clusters of these metal oxide particles can damage the second inorganic layer.

In the embodiment shown the second organic layer 36 extends laterally beyond the first organic layer 34. In particular the second organic layer 36 extends laterally beyond the first organic layer 34 over the full circumference of the latter, as is shown schematically in FIG. 1.

In the embodiment shown the multi-layered protective layer 30 has a top layer 40 of a further organic material.

The inorganic layers 32, 38 extend beyond the organic layers 34, 36 and form an encapsulation of the organic layers 34, 36 so that also a lateral ingress of atmospheric substances into the organic layers 34, 36 is prevented.

The first organic layer 34 covers the area defined by the opto-electric element 10 completely. Furthermore the second organic layer 36 laterally extends beyond the area of the first organic layer 34. In particular the second organic layer 36 laterally extends over its full circumference beyond the area of the first organic layer 34.

The lateral dimensions of the inorganic layers 32, 38 extend beyond the opto-electric element 10, and the organic layers 34, 36. In particular the inorganic layers 32, 38 encapsulate the organic layers 34, 36. The multi-layer protective layer 30 forms part of a protective encapsulation 20 of the opto-electric element 10. The encapsulation 20 may comprise a further multi-layer protective layer or another type of layer that has sufficient barrier properties, such as a glass plate, a metal foil etc.

In an embodiment the opto-electric element 10 is an OLED. The OLED has a light emitting layer arranged between a cathode and an anode. In case the device has a metal substrate, the latter may function as an electrode. For an improved functionality the OLED typically has additional functional layers, such as a hole injection layer, a hole transport layer, an electron injection layer etc.

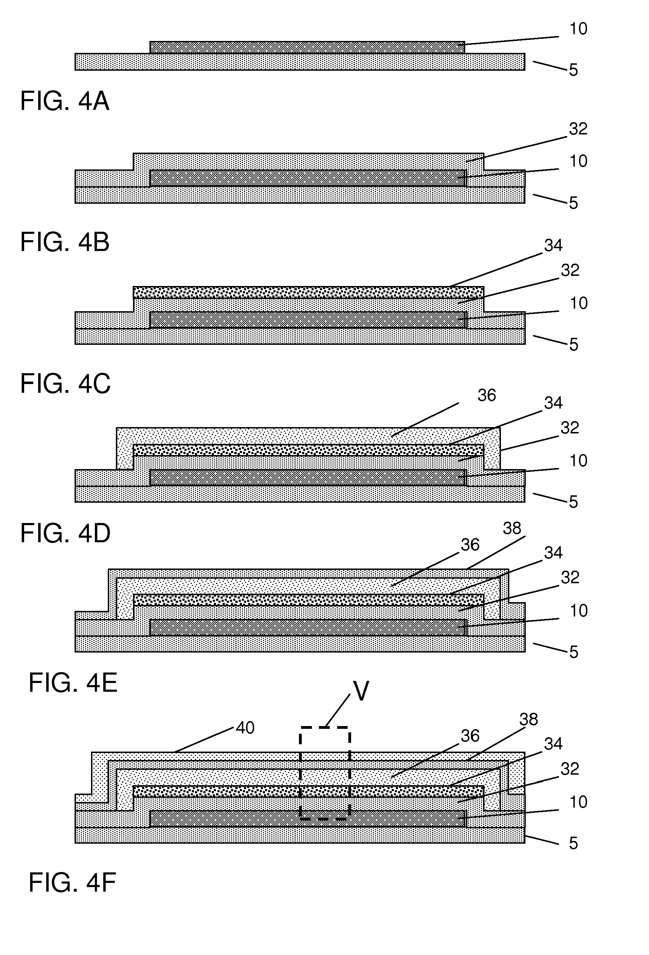

FIG. 4A - 4F shows an illustrative method of manufacturing of an opto-electric device according to the fourth aspect of the invention. FIG. 4B to 4E thereof show an illustrative method according to the third aspect of manufacturing a multi-layered protective layer.

FIG. 4A shows a first step, wherein an opto-electric element 10 is provided on a substrate 5. The substrate 5 may have a barrier function. For example a metal foil or a glass plate may be used as the substrate. Alternatively a substrate may be a polymer foil provided with a multi-layer barrier.

FIG. 4B shows a second step wherein a first inorganic layer 32 is deposited over the substrate 5 provided with the opto-electric element 10. Various methods are suitable for this purpose including such as all kinds of physical vapor deposition methods like thermal evaporation, e-beam evaporation, sputtering, magnetron sputtering, reactive sputtering, reactive evaporation, etc. and all kinds of chemical vapor deposition methods such as thermal chemical vapor deposition (CVD), photo assisted chemical vapor deposition (PACVD), plasma enhanced chemical vapor deposition (PECVD), etc. The thickness of the layer can be controlled in practice by the duration of the deposition process. In this case a silicon nitride layer of 150 nm was deposited as the inorganic layer by a PECVD process.

FIG. 4C shows a third step wherein the first organic layer 34 is deposited. For this third step a dispersion of the nanometer sized metal oxide particles, here calcium oxide particles in an organic precursor was prepared. The organic precursor, here further denoted as POLH9B-1 comprised isobornyl acrylate (77.45 wt%) obtained as SR506D from Sartomer, polybutadiene diacrylate oligomer (20.59 wt%) obtained SR307 from Sartomer, and bis(2,4,6-trimethylbenzoyl)-phenylphosphineoxide (1.96 wt%) obtained as Irgacure 819 from BASF. The CaO particles were obtained from Strem Chemicals (Catalog #20-1400) and had the following product specifications. Specific Surface Area (BET): ≥ 20 m2/g; Bulk Density: 0.5 g/cc; Crystallite Size: ≤ 40 nm; True Density: 3.3 g/cc; Average Pore Diameter: 165Å; Mean Aggregate Size: 4 µm; Total Pore Volume: ≥0.1 cc/g; Ca Content (Based on Metal): >99.8%.

The getter particles were milled into the organic precursor during 72 hours with a Retch PM100 ball milling equipment using a 250 mL zirconium oxide bowl and 10 mm diameter zirconium oxide milling balls.

FIG. 8 shows as a dashed curve a typical particle size distribution of the originally obtained CaO powder. The distribution, which was measured with a dynamic light scattering tool (DLS), here a Zetasizer Nano of Malvern Instruments shows a first peak at about 60 nm, a second peak at about 550 nm and a third peak at about 5 µm. FIG. 8 also shows as a solid curve a typical particle size distribution obtained after milling during 72 hours. Due to the milling process the location of the first peak shifts towards about 20 nm. Surprisingly the second peak disappears, while the third peak at about 5 µm remains.

The so obtained dispersion was plotted on the surface of the inorganic layer 32. Alternatively the dispersion may be printed. The plotted surface encompasses the surface area defined by the opto-electric element 10, as is also shown in FIG. 1. After plotting the organic material in the deposited dispersion was cured.

Also other getter materials may be used. Other alkaline earth metals for this purpose that are particularly suitable are barium oxide (BaO), magnesium oxide (MgO) and strontium oxide (SrO). As an example MgO nanopowder (Catalog Nr.12-1400) from Strem may be obtained having the following specifications: Specific Surface Area (BET): ≥ 230 m²/g; True Density: 3.2 g/cc; Crystallite Size: ≤ 8 nm; Mean Aggregate Size: 3.3 µm; Average Pore Diameter: 50Å; Loss on Ignition: ≤ 8%; Total Pore Volume: ≥0.2 cc/g; Moisture Content: ≤ 1%; Bulk Density: 0.6 g/cc; Mg Content (Based on Metal): ≥ 95%.

FIG. 4D shows a fourth step wherein the second organic layer 36 is deposited by ink-jet printing. In this embodiment a different organic precursor, here denoted as POLH9B-2, was used for this second organic layer then for the first organic layer. This precursor POLH9B-2 comprises isobornyl acrylate (66.35 wt%) obtained as SR506D from Sartomer, polybutadiene diacrylate oligomer (11.55 wt%) obtained as SR307 from Sartomer, tricyclodecane dimethanol diacrylate (9.65 wt%) obtained as SR833S from Sartomer, trimethylolpropane trimethacrylate (8.65 wt%) obtained as SR350 from Sartomer, and 2,2-Dimethoxy-1,2-diphenylethan-1-one (3.8 wt%) obtained as Irgacure 651 from BASF. Alternatively the same precursor may be used for the first and the second organic layers. After curing this layer 36 a second inorganic layer was deposited in a fifth step. The second organic layer 36 is deposited so that it laterally extends beyond the surface of the first organic layer 34. It has been found by the inventors that upon curing of the first organic layer 34 the organic material that embeds the metal oxide particles tends to withdraw from the edges of the surface of the inorganic layer, leaving the clusters of particles at these edges. By depositing the second organic layer 36 so that it laterally extends beyond the first organic layer, it is achieved that these clusters are covered by the organic material of the second organic layer.

FIG. 4E shows the fifth step wherein the second inorganic layer 38 was deposited in the same way as described for the first inorganic layer 32.

FIG. 4F shows a sixth step wherein a further organic layer 40 is deposited over the second inorganic layer 38 in a manner comparable to the method used for the fourth step wherein the second organic layer 36 was deposited.

It has been found by the inventors that the top layer 40 of organic material further improves the protective function of the multi-layer protective layer 30, despite the fact that this layer of organic material itself forms no substantial barrier and despite the fact that it does not function as an intermediate layer between the inorganic layers. Without wishing to be bound by theory it is believed that the organic layer 40 also serves to fix particles, such as dust particles, before they can cause defects in the inorganic layer 38. The top layer 40 may typically have a thickness in the range of 5 to 100 µm, for example of 30 µm.

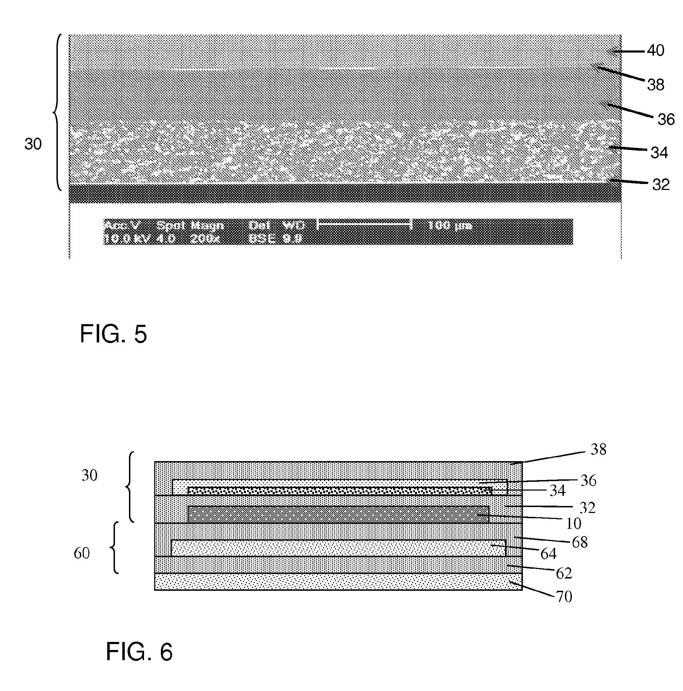

FIG. 5 shows a SEM-picture of a section V indicated in FIG. 4F of the multilayered protective layer 30 so obtained.

Therein the first and the second inorganic layers 32, 38 are siliconnitride layers having a thickness of 150 nm. The first organic layer 34 comprises 5 wt% CaO particles embedded in a matrix of POLH9B-1 and has a thickness of about 80 µm.

The second organic layer 36 is a layer of POLH9B-1 free from metal oxide particles and having a thickness of about 70 µm. The further organic layer 40, forming the top-layer of the multi-layer protective layer 30 is also a layer of POLH9B-1 free from metal oxide particles and having a thickness of about 50 µm.

The first and the second organic layer were both cured by radiation with a Dymax Flood Lamp at a power density of 33mW/cm2 during 90 s.

As indicated above, various options are available for the substrate 5. For example the substrate may be a metal foil or a glass plate, which inherently has a (moisture) barrier function. Alternatively the substrate may be a polymer foil provided with a barrier structure. The barrier structure may be a known barrier structure, such as a stack of layers of mutually alternating inorganic materials, for example layers of silicon oxide and silicon nitride alternating each other. Alternatively the barrier structure may be similar to the barrier structure comprising the layers 32, 34, 36, 38. In that case the barrier structure can be obtained by the steps described above with reference to Figures 4B to 4E.

FIG. 6 shows a second embodiment of the opto-electric device according to the first aspect of the invention. In this embodiment the opto-electric element 10 is arranged between a first multi-layer protective layer 30 according to the first aspect of the invention and a, conventional, second multi-layer protective layer 60. In this case the second multi-layer protective layer 60 comprises an inorganic layer 62, for example of siliconoxide, an organic layer 64, for example of an acrylate, and an inorganic layer 68. The second multi-layer protective layer 60 is arranged at an organic layer 70. In the embodiment shown the opto-electric element 10 is an OLED, and the cathode thereof (not shown) faces the first multi-layer protective layer, having the first organic layer 34 with nanometer sized metal oxide particles with a density in the range of 4 to 20 wt% distributed therein and the second organic layer 36 having a thickness in the range of 10 to 100 micrometer. The second multi-layer protective layer 60 does not comprise an organic layer with nanometer sized metal oxide particles between the inorganic layers 62 and 68. In an alternative embodiment however, the second multi-layer protective layer 60 may have a combination of layers similar to that of the first multi-layer protective layer 30.

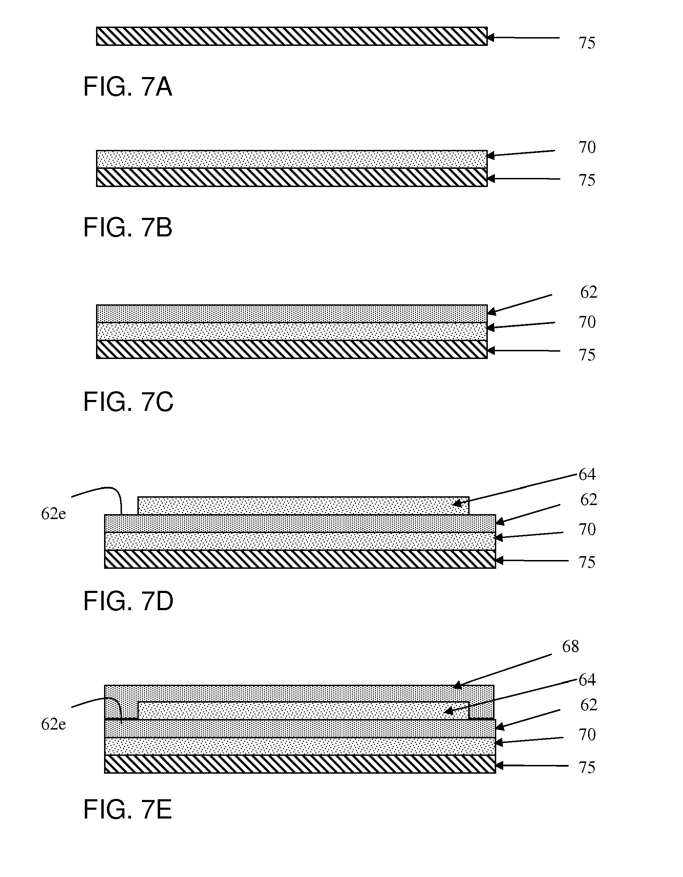

FIG. 7A - 7G shows a possible method of manufacturing the opto-electric device of FIG. 6.

FIG. 7A shows a first step wherein a temporary substrate 75 is provided, such as a glass or a metal plate.

FIG. 7B shows a second step wherein a releasable organic layer 70 is deposited. The releasable organic layer 70 is a layer of a material that provides for a sufficient adhesion of the workpiece to the temporary substrate 75 during manufacturing, but that allows an easy release of the workpiece once finished. For example a silica organic based polymer such as polydimethylsiloxaan (PDMS) may be used for this purpose.

FIG. 7C shows a third step wherein an inorganic layer 62 is deposited.

FIG. 7D shows a fourth step wherein an organic layer 64 is deposited on the inorganic layer 62.

FIG. 7E shows a fifth step wherein an inorganic layer 64 is deposited on the organic layer 64. The inorganic layer 64 extends laterally beyond the organic layer 64 over the free edge 62e of the organic layer 62, so that the inorganic layers 62 and 68 encapsulate the organic layer 64.

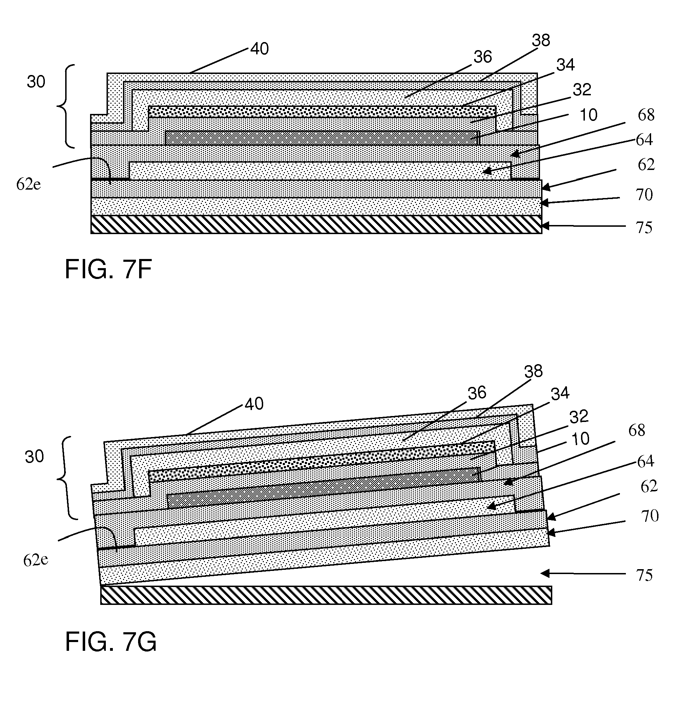

FIG. 7F shows how in subsequent steps an opto-electric element 10 and a multi-layer protective layer 30 are applied as described with reference to FIG. 4A to 4F.

FIG. 7G then illustrates how in a release step the so obtained product is released from the substrate 75.

Although the present invention is specifically explained with reference to an OLED, the invention is equally applicable to opto-electric devices having another opto-electric element, such as an electrochromic device, or a photovoltaic device.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

## Claims

1. A multi-layered protective layer (30) comprising
- a first inorganic layer (32),
- a first organic layer (34) comprising a getter material,
- a second organic layer (36) free from getter material and
- a second inorganic layer (38), which layers are stacked in the order named, wherein the first and the second inorganic layer encapsulate the first and the second organic layer,
**characterized in that** the getter material is distributed in the first organic layer (34) as nanometer sized particles and **in that** the second organic layer (36) has a thickness of at least 10 µm.

2. A multi-layered protective layer according to claim 1, wherein the nanometer sized particles comprised in the first organic layer are provided with an amount of 4 to 20% by weight based on the total weight of the composition.

3. A multi-layered protective layer according to claim 1, wherein the nanometer sized particles are composed of a metal oxide.

4. A multi-layered protective layer according to claim 1, wherein the metal oxide is an alkaline earth metal oxide.

5. A multi-layered protective layer according to claim 1 or 2, wherein the thickness of the second organic layer (36) is at least 20 µm.

6. A multi-layered protective layer according to claim 1 or 2, wherein the thickness of the second organic layer (36) is at most 100 µm.

7. A multi-layered protective layer according to claim 1 or 2, wherein the first organic layer (34) has a thickness in the range of 10 to 100 µm.

8. A multi-layered protective layer according to claim 1 or 2, wherein the density of the metal oxide in the first organic layer (34) is in the range of 5 to 15 wt%.

9. A multi-layered protective layer according to claim 1 or 2, wherein the second organic layer (36) laterally extends beyond the area defined by the first organic layer (34).

10. A multi-layered protective layer according to claim 7, wherein the second organic layer (36) extends over its full circumference beyond the area defined by the first organic layer (34).

11. A multi-layered protective layer according to any of the claims 1 to 10, wherein the first organic layer (34) and/or the second organic layer (36) are obtained by curing with actinic radiation a photocurable resin composition comprising:
(A) at least one aromatic acrylate or methacrylate component, or any mixture thereof;
(B) at least one monofunctional acrylate, methacrylate, vinylamide, acrylamide or methacrylamide component, preferably with a viscosity below 100 mPa • s at 30°C, or any mixture thereof;
(C) at least one photoinitiator, or any mixture thereof.

12. A multi-layered protective layer according to claim 11, wherein the photocurable resin composition comprises:
(A) 30 - 90% by weight of the aromatic acrylate or methacrylate component A;
(B) 1 - 30% by weight of the monofunctional acrylate, methacrylate, vinylamide, acrylamide or methacrylamide component B;
(C) 0.1 - 10% by weight of the photoinitiator C;
based on the total weight of the resin composition.

13. A multi-layered protective layer according to any of the claims 1 to 10, wherein the first organic layer (34) and/or the second organic layer (36) are obtained by curing with actinic radiation a photocurable resin composition comprising:
(D) at least one polybutadiene acrylate or methacrylate component, or any mixture thereof;
(E) at least one acrylate or methacrylate component not exhibiting polybutadiene groups, preferably with a viscosity below 100 mPa • s at 30°C, or any mixture thereof;
(C) at least one photoinitiator, or any mixture thereof.

14. A multi-layered protective layer according to claim 13, wherein the photocurable resin composition comprises:
(D) 10 - 60% by weight of the polybutadiene acrylate or methacrylate component D;
(E) 1 - 89.9% by weight of the acrylate or methacrylate component E;
(C) 0.1 - 10% by weight of the photoinitiator C;
based on the total weight of the resin composition.

15. A multi-layered protective layer according to any of the claims 1 to 10, wherein the first organic layer (34) and/or the second organic layer (36) are obtained by curing with actinic radiation a photocurable resin composition comprising:
(F) at least one urethane acrylate or methacrylate component, or any mixture thereof;
(E) at least one acrylate or methacrylate component not exhibiting urethane groups, preferably with a viscosity below 100 mPa • s at 30°C, or any mixture thereof;
(C) at least one photoinitiator, or any mixture thereof.

16. A multi-layered protective layer according to claim 15, wherein the photocurable resin composition comprises:
(F) 5- 50% by weight of the urethane acrylate or methacrylate component F;
(E) 1 - 94.9% by weight of the acrylate or methacrylate component E;
(C) 0.1 - 10% by weight of the photoinitiator C;
based on the total weight of the resin composition.

17. A multi-layered protective layer according to any of the claims 1 to 10, wherein the first organic layer (34) and/or the second organic layer (36) are obtained by curing with actinic radiation a photocurable resin composition comprising:
(G) at least one acrylate or methacrylate component, or any mixture thereof with a ClogP value >2;
(H) at least one thiol component, or any mixture thereof;
(C) at least one photoinitiator, or any mixture thereof.

18. A multi-layered protective layer according to claim 17, wherein the photocurable resin composition comprises:
(G) 20 - 98.9% by weight of the acrylate or methacrylate component G;
(H) 1 - 20% by weight of the thiol component H;
(C) 0.1 - 10% by weight of the photoinitiator C;
based on the total weight of the resin composition.

19. A multi-layered protective layer according to any of the claims 1 to 10, wherein the first organic layer (34) and/or the second organic layer (36) are obtained by curing with actinic radiation a photocurable resin composition comprising:
(I) at least one epoxy polysiloxane component;
(J) at least one cationic photoinitiator, or any mixture thereof.

20. A multi-layered protective layer according to claim 19, wherein the photocurable resin composition comprises:
(I) 20 - 99.9% by weight of the epoxy polysiloxane component I;
(K) 0.2-79.9% by weight of an epoxy or oxetane functional organic component or mixture of epoxy or oxetane functional organic components not exhibiting polysiloxane groups.
(J) 0.1 - 10% by weight of the photoinitiator J;
based on the total weight of the resin composition.

21. A multi-layered protective layer according to any of the claims 1 to 10, wherein the first organic layer (34) and/or the second organic layer (36) are obtained by curing with actinic radiation a photocurable resin composition with a ClogP value >2.

22. An organic opto-electric device comprising
- an opto-electric element (10),
- an protective enclosure (20) for protecting the opto-electric element (10) against atmospheric substances, said protective enclosure comprising a multi-layered protective layer (30) according to any of claims 1 to 21.

23. Organic opto-electric device according to claim 22, comprising a further organic layer (40) that is provided as a top-coat over the second inorganic layer (38).

24. Method of manufacturing a multi-layered protective layer comprising the steps of
b) depositing a first inorganic layer,
c) depositing a first organic layer comprising a getter material, the getter material being distributed in the first organic layer as nanometer sized particles,
d) depositing a second organic layer free from getter material, the second organic layer having a thickness in the range of 10 to 100 micrometer,
e) depositing a second inorganic layer, therewith obtaining a stack subsequently comprising the opto-electric element, the first inorganic layer, the first organic layer, the second organic layer and the second inorganic layer, wherein the first and the second inorganic layer encapsulate the first and the second organic layer.

25. Method of manufacturing a multi-layered protective layer according to claim 24, wherein the nanometer sized particles comprised in the first organic layer are provided with a density in the with an amount of 4 to 20% by weight based on the total weight of the composition.

26. Method of manufacturing an opto-electric device comprising an opto-electric element encapsulated by a protective enclosure, said method comprising the steps of
- providing the opto-electric element,
- providing the protective enclosure, said step of providing the protective enclosure comprising the steps as claimed in claim 24 or 25.
